# EUROPEAN PATENT APPLICATION

(11) **EP 1 197 511 A1**
(43) Date of publication of application: **17.04.2002**
(21) Application number: 01308630.1
(22) Date of filing: 09.10.2001
(51) Int. Cl.: C08G 77/04, C08L 83/04, C09D 183/04, G03F 7/09, G03F 7/075

(54) **Antireflective composition**

(30) Priority: 10.10.2000 US 238901 P
(71) Applicant: Shipley Company LLC, Marlborough, MA 01752 (US)
(72) Inventor: Gallagher, Michael K., Lansdale, Pennsylvania 19446 (US); You, Yujian, Lansdale, Pennsylvania 19446 (US)
(74) Representative: Kent, Venetia Katherine

(57) **Abstract**

Disclosed are new antireflective compositions including organo polysilica materials including one or more chromophores. Also disclosed are methods of forming relief images using these antireflective compositions.

## Description

### Background of the Invention

The present invention relates generally to the field of antireflective compositions. In particular, the present invention relates to compositions useful as antireflective coatings.

In the manufacture of electronic devices, such as printed wiring boards or semiconductors, a number of layers of material, such as photoresists or antireflective coatings, are applied to a substrate. Photoresists arc photosensitive films used for transfer of an image to a substrate. A coating layer of a photoresist is formed on a substrate and the photoresist layer is then exposed through a photomask (reticle) to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or cross-link in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble. Photoresist compositions are known to the art and described by Deforest, Photoresist Materials and Processes, McGraw Hill Book Company, New York, ch. 2, 1975 and by Moreau, Semiconductor Lithography, Principles, Practices and Materials, Plenum Press, New York, ch. 2 and 4, both incorporated herein by reference to the extent they teach photoresist compositions and methods of making and using them.

A major use of photoresists is in the manufacture of semiconductors where an object is to create features, such as vias, trenches or combinations thereof, in a dielectric layer. Proper photoresist processing is a key to attaining this object. While there is a strong interdependency among the various photoresist processing steps, exposure is believed to be one of the more important steps in attaining high resolution photoresist images.

In such processes, reflection of actinic radiation during exposure of the photoresist is detrimental to fine feature formation. Reflection of actinic radiation, such as from the layer underlying the photoresist, often poses limits on resolution of the image patterned in the photoresist layer. Reflection of radiation from the substrate/photoresist interface can produce variations in the radiation intensity in the photoresist during exposure, resulting in non-uniform photoresist linewidth upon development. Radiation also can scatter from the substrate/photoresist interface into regions of the photoresist where exposure is not intended, again resulting in linewidth variations. The amount of scattering and reflection will typically vary from region to region, resulting in further linewidth non-uniformity.

Reflection of activating radiation also contributes to what is known in the art as the "standing wave effect." To eliminate the effects of chromatic aberration in exposure equipment lenses, monochromatic or quasi-monochromatic radiation is commonly used in photoresist projection techniques. Due to radiation reflection at the photoresist/substrate interface, however, constructive and destructive interference is particularly significant when monochromatic or quasi-monochromatic radiation is used for photoresist exposure. In such cases the reflected light interferes with the incident light to form standing waves within the photoresist. In the case of highly reflective substrate regions, the problem is exacerbated since large amplitude standing waves create thin layers of underexposed photoresist at the wave minima. The underexposed layers can prevent complete photoresist development causing edge acuity problems in the photoresist profile. The time required to expose the photoresist is generally an increasing function of photoresist thickness because of the increased total amount of radiation required to expose an increased amount of photoresist. However, because of the standing wave effect, the time of exposure also includes a harmonic component which varies between successive maximum and minimum values with the photoresist thickness. If the photoresist thickness is non-uniform, the problem becomes more severe, resulting in variable linewidths.

With recent trends towards high-density semiconductor devices, there is a movement in the industry to shorten the wavelength of exposure sources to deep ultraviolet (DUV) light (300 nm or less in wavelength), KrF excimer laser light (248 nm), ArF excimer laser light (193 nm), electron beams and soft x-rays. The use of shortened wavelengths of light for imaging a photoresist coating has generally resulted in increased reflection from the upper resist surface as well as the surface of the underlying substrate. Thus, the use of the shorter wavelengths has exacerbated the problems of reflection from a substrate surface.

Radiation reflection problems have been addressed by the addition of certain dyes to photoresist compositions, the dyes absorbing radiation at or near the wavelength used to expose the photoresist. Such dyes have included the coumarin family, methyl orange and methanil yellow. However, the use of such dyes can limit resolution of the patterned resist image.

Another approach used to reduce the problem of reflected radiation has been the use of a radiation absorbing layer either interposed between the substrate surface and the photoresist coating layer, called a bottom antireflective coating or BARC, or a radiation layer disposed on the surface of the photoresist layer, called a top antireflective coating or TARC. See, for example, PCT Application WO 90/03598, EPO Application No. 0 639 941 A1 and U.S. Pat. Nos. 4,910,122, 4,370,405 and 4,362,809. Such BARC and TARC layers have also been generally referred to in the literature as antireflective layers or antireflective compositions. Typically, such antireflective compositions include a radiation absorbing component (or chromophore) a polymeric binder and one or more cross-linking agents.

Variations in substrate topography also give rise to resolution-limiting reflection problems. Any image on a substrate can cause impinging radiation to scatter or reflect in various uncontrolled directions, affecting the uniformity of photoresist development. As substrate topography becomes more complex with efforts to design more complex circuits, the effects of reflected radiation become more critical. For example, metal interconnects used on many microelectronic substrates arc particularly problematic due to their topography and regions of bigh reflectivity.

One method of solving such problems resulting from variations in substrate topography is by placing a photoresist at the same height over a surface, as disclosed in U.S. Patent No. 4,557,797 (Fuller et al.). This patent uses a multi-layer structure having a relatively thick bottom layer of poly(methyl methacrylate) ("PMMA") to provide a planar surface, a thin middle layer of an antireflective coating and a thin top layer of a photoresist material. However, this system results in a thick polymer layer which must subsequently be removed. Such layers are typically removed by a variety of methods, such as chemical mechanical polishing ("CMP"), etching and wet chemical methods. Due to the added time and cost of such removal processes, it is desired that the polymer layers be as thin as possible to aid in their subsequent removal.

Another approach to solving the problems associated with variations in substrate topography is that disclosed in Adams et al., *Planarizing AR for DUV Lithography*, Microlithography 1999: Advances in Resist Technology and Processing XVI, Proceedings of SPIE, vol. 3678, part 2, pp 849-856, 1999, which discloses the use of a planarizing antireflective coating, which reduces the need for a separate planarizing layer disposed between the antireflective layer and the substrate.

Current antireflective coating compositions include one or more polymeric binders, and optionally a cross-linking agent. The polymeric binders are typically linear polymers having relatively low molecular weights, such as up to 20,000 Daltons. Such polymeric binders are desired as they tend to form coatings of uniform thickness, form planarized coating layers and can be easily dispensed onto a substrate for lithographic processing. It is believed that the etch rates of antireflective coatings should be equal to or faster than the etch rate of the photoresist used in order to prevent undercutting. However, it is often difficult to substantially match the etch rates of the antireflective coating material to the photoresist while still providing a sufficiently absorbing coating.

Typically, the antireflective coatings have been designed to match the photoresist used. This is true not only for etch rates, but also for other properties, such as stripability. Antireflective coatings having etch rates substantially matched to the underlying substrate are not generally known. Also, antireflective coatings that are left behind, i.e. not removed when the photoresist is removed, are not generally known. Such remaining antireflective could then serve additional functions, such as a cap layer.

There is a need for antireflective materials that serve a dual role of providing absorption or attenuation of radiation and also serve as a cap layer or dielectric layer for the underlying structure.

### Summary of the Invention

It has been surprisingly found that interlayer dielectric materials, such as certain organo polysilica materials, are effective as antireflective compositions or coatings. It has also been surprisingly found that such antireflective coatings arc also effective as cap layers, Cap layers formed from the antireflective coatings of the present invention can have dielectric constants ("k") that are lower than those of convcntional cap layers, thus lowering the overall dielectric constant of electronic devices. The present compositions are particularly useful as antireflective coatings for sub-300 nm wavelength exposure, and more particularly for 248 nm, 193 nm and 157 nm wavelengths.

In one aspect, the present invention provides a composition useful as an antireflective coating including one or more B-staged organo polysilica materials having the formula

((RR¹SiO)ₐ(R²SiO_{1.5})_{b}(R³SiO_{1.5})_{c}(SiO₂)_{d})ₙ

wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl.

In a second aspect, the present invention provides a method for forming an antireflective coating layer including the step of disposing on a substrate a composition including one or more B-staged organo polysilica materials having the formula

((RR¹SiO)ₐ(R²SiO_{1.5})_{b}(R³SiO_{1.5})_{c}(SiO₂)_{d})ₙ

wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl.

In a third aspect, the present invention provides a method for manufacturing an electronic device including the steps of: a) disposing on a substrate an antireflective composition including one or more B-staged organo polysilica materials having the formula

((RR¹SiO)ₐ(R²SiO_{1.5})_{b}(R³SiO_{1.5})_{c}(SiO₂)_{d})ₙ

wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl; b) curing the one or more B-staged organo polysilica materials to form a cured organo polysilica antireflective coating layer; c) disposing a photoresist on the cured organo polysilica antireflective coating layer; and d) patterning the photoresist.

In a fourth aspect, the present invention provides an electronic device including a dielectric layer and an organo polysilica coating layer disposed thereon.

### Detailed Description of the Invention

As used throughout this specification, the following abbreviations shall have the following meanings, unless the context clearly indicates otherwise: ° C = degrees Centigrade; Å = angstrom; run = nanometer; and TFE = tetrafluorocthylene.

The terms "resin" and "polymer'' are used interchangeably throughout this specification. The term "alkyl" refers to linear, branched and cyclic alkyl. The terms "halogen" and "halo" include fluorine, chlorine, bromine, and iodine. Thus the term "halogenated" refers to fluorinated, chlorinated, brominated, and iodinated. "Fluoroalkyl" refers to both partially fluorinated and perfluorinated alkyl. "Polymers" refer to both homopolymers and copolymers and include dimers, trimers, oligomers and the like The term "(meth)acrylate" refers to both acrylate and methacrylate. Likewise, the term "(meth)acrylic" refers to both acrylic and methacrylic. "Monomer" refers to any compound capable of being polymerized. "Polymer" refers to polymers and oligomers. The term "polymer" also includes homopolymers and copolymers. The terms "oligomer" and "oligomeric" refer to dimers, trimers, tetramers and the like. The terms "cross-linker" and "cross-linking agent" are used interchangeably throughout this specification. "Antireflectant" and "antireflective" are used interchangeably throughout this specification.

All amounts arc percent by weight and all ratios arc by weight, unless otherwise noted. All numerical ranges are inclusive and combinable.

The antireflective compositions of the present invention include one or more B-staged oreano polysilica materials having one or more chromophores. The B-staged organo polysilica materials have the formula

((RR¹SiO)ₐ(R²SiO_{1.5})_{b}(R³SiO_{1.5})_{c}(SiO₂)_{d})ₙ

wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₁-C₂₀)alkyl. In the above formula, a, b, c and d represent the mole ratios of each component. Such mole ratios can be varied between 0 and about 1. It is preferred that a is from 0 to about 0.8. It is also preferred that c is from 0 to about 0.8. It is further preferred that d is from 0 to about 0.8. In the above formula, n refers to the number of repeat units in the B-staged material. Preferably, n is an integer from about 3 to about 1000. It will be appreciated that prior to any curing step, the B-staged organo polysilica dielectric matrix materials may include one or more of hydroxyl or alkoxy end capping or side chain functional groups. Such end capping or side chain functional groups are known to those skilled in the art.

"Substituted alkyl" refers to an alkyl group having one or more of its hydrogens replaced with another substituent group, such as halo, trihalomethyl such as trifluoromethyl, (C₁-C₆)alkoxy, hydroxy, cyano and the like. The term "aryl" refers to any aryl group, such as phenyl, anthracenyl, phenanthrenyl, naphthalenyl, biphenyl, and the like. "Substituted aryl" refers to an aryl group having one or more of its hydrogens replaced by another substituent group, such as cyano, hydroxy, mercapto, halo, (C₁-C₆)alkyl, (C₁-C₆)alkoxy, and the like.

Suitable organo polysilica dielectric matrix materials include, but are not limited to, silsesquioxanes, partially condensed halosilanes or alkoxysilanes such as by controlled hydrolysis tetraethoxysilane having number average molecular weight of about 500 to about 20,000, organically modified silicates having the composition RSiO₃ or R₂SiO₂ wherein R is an organic substituent, and partially condensed orthosilicates having Si(OR)₄ as the monomer unit. Silsesquioxanes are polymeric silicate materials of the type RSiO_{1.5} where R is an organic substituent. Suitable silsesquioxanes are alkyl silsesquioxanes such as iso-butyl silsesquioxane, n-butyl silsesquioxane, n-octyl silsesquioxane, cyclohexyl silsesquioxane and the like; aryl silsesquioxanes such as phenyl silsesquioxane and tolyl silsesquioxane; alkyl/aryl silsesquioxane mixtures such as a mixture of n-butyl silsesquioxane and phenyl silsesquioxane; and mixtures of alkyl silsesquioxanes such as n-butyl silsesquioxane and n-octyl silsesquioxane. B-staged silsesquioxane materials include homopolymers of silsesquioxanes, copolymers of silsesquioxanes or mixtures thereof. Such dielectric materials are generally commercially available or may be prepared by known methods.

It is preferred that the organo polysilica is a silsesquioxane, and more preferably iso-butyl silsesquioxane, n-butyl silsesquioxane, n-octyl silsesquioxane, cyclohexyl silsesquioxane, tert-butyl silsesquioxane, phenyl silsesquioxane, tolyl silsesquioxane or mixtures thereof. Particularly useful silsesquioxanes include mixtures of hydrido silsesquioxanes with alkyl, aryl or alkly/aryl silsesquioxanes. Other useful silsesquioxanes include anthracenyl silsesquioxane and naphthalenyl silsesquioxane. Typically, the silsesquioxanes useful in the present invention are used as oligomeric materials, generally having from about 3 to about 10,000 repeating units.

As used herein, "chromophore" refers to a group that absorbs and/or attenuates the desired wavelength of the radiation used to image the photoresist. For example, when the antireflective organo polysilica materials of the present invention are to be used with photoresists imaged at radiation wavelengths such as 248 or 193 nm, the B-staged organo polysilica materials contain as the chromophore one or more aromatic or substituted aromatic moieties. Thus, organo polysilica materials containing aryl or substituted aryl groups arc suitable as antireflective compositions at these wavelengths. When the antireflective organo polysilica materials of the present invention are to be used with photoresists imaged at radiation wavelengths such as 157 nm or below, the B-staged organo polysilica materials contain as the chromophore one or more (C₄-C₂₀)alkyl groups. Suitable organo polysilica materials for use as antireflective compositions for this wavelength include organic polysilica materials containing groups such as, but not limited to, butyl, pentyl, hexyl, heptyl, octyl, nonyl, decyl, dodecyl, tetradecyl heptadecyl and ocladecyl.

It will be appreciated by those skilled in the art that the absorption or attenuation of the antireflective compositions of the present invention may be increased by increasing the amount of such chromophores in the organo polysilica materials.

The antireflective compositions of the present invention may optionally include one or more additional components which can form copolymers or composites with the B-staged organo polysilica materials. Particularly useful additional components include those containing one or more halogens such as fluorine. The present compositions may also include one or more organic solvents, wetting agents, surfactants, flow aids, viscosity modifiers, film forming agents, cross-linking agents and the like. It is preferred that the amount of B-staged organo polysilica material in the present compositions is at least about 10% by weight, based upon the total weight of solids, preferably at least about 15%, more preferably at least about 20%, and still more preferably at least about 25%. Other suitable amounts of B-staged organo polysilica material is 30%, 40%, 50%, 60%, 70%, 75%, 80% and 90%.

Suitable additional components that can form copolymers or composites with the B-staged organo polysilica materials include, but are not limited to, other dielectric type materials such as carbides, oxides, nitrides and oxyfluorides of silicon, boron, or aluminum; other organo polysilica materials; hydridosilsesquioxane; and organic matrix materials such as benzocyclobutenes, poly(aryl esters), poly(ether ketones), polycarbonates, polyimides, fluorinated polyimides, polynorbomenes, poly(arylene ethers), polyaromatic hydrocarbons, such as polynaphthalene, polyquinoxalines, poly(perfluorinated hydrocarbons) such as poly(tetrafluoroethylene), and polybenzoxazoles; organic monomers, oligomers and polymers; inorganic monomers, oligomers and polymers; and the like. Such additional components may optionally contain one or more chromophores to help in the absorption or attenuation of photoresist imaging radiation.

Particularly suitable organic monomers include fluorinated monomers and likewise, particularly suitable oligomers and polymers include those including as polymerized units one or more fluorinated monomers, one or more fluorinated cross-linkers or a mixture thereof. Such fluorinated components arc particularly suitable for antireflective compositions useful with photoresists for imaging at 157 nm. Preferably, the fluorinated monomers or cross-linkers arc highly fluorinated. Any monomer containing a fluoroalkyl group, such as trifluoromethyl, is particularly suitable, Suitable fluorinated monomers include, but are not limited to fluorinated (meth)acrylates and (meth)acrylamides such as fluoroalkyl (meth)acrylate such as fluoro(C₁-C₂₀)alkyl (meth)acrylate, fluorocycloalkyl (meth)acrylate, fluoroalkylsulfoamidoethyl (meth)acrylate, fluoroalkylamidoethyl (meth)acrylate, fluoroalkyl (meth)acrylamide, fluoroalkylpropyl (meth)acrylate, fluoroalkylethyl poly(alkyleneoxide) (meth)acrylate, fluoroalkylsulfoethyl (meth)acrylate, αH,αH,ωH,ωH-perfluoroalkanediol di(meth)acrylate and β-substituted fluoroalkyl (meth)acrylate; fluorinated vinyl ethers such as fluoroalkylethyl vinyl ether and fluoroalkylethyl poly(ethyleneoxide) vinyl ether; fluorinatedalcohol vinyl ethers; fluorinated vinyl acetates; fluorinatedalkyl vinyl acetates such as trifluoromethyl vinyl acetate; fluorinated aromatics such as fluorostyrene, pentafluoro styrene and fluoroalkyl styrene; fluorinated hydroxyaromatics such as fluorinated hydroxystyrene; fluorinated ethylene such as vinylidene fluoride, trifluoroethylene and tetrafluoroethylene; fluorinated α-olefins; fluorinated dienes such as perfluorobutadiene and 1-fluoroalkylperfluorobutadiene, fluorinated heterocycles such as perfluoro-(2,2-dimethyl-1,3-dioxole) and perfluoro-(2-methylene-4-methyl-1,3-dioxolane). Preferred fluoroinated monomers include 3-fluorostyrenc, 4-fluorosytrene, perfluorooctylethyl (meth)acrylate, perfluorooctylethyl (meth)acrylate, octafluoropentyl (meth)acrylate, trifluoroethyl (meth)acrylate, tetrafluoropropyl (meth)acrylate, vinylidene fluoride, trifluoroethylene, tetrafluoroethylene, perfluoro-(2,2-dimethyl-1,3-dioxole) and perfluoro-(2-methylene-4-methyl-1,3-dioxolane).

It will be appreciated that oligomers may be used in the present antireflective compositions. Thus, for use with photoresists for imaging at sub-200 nm wavelength radiation, fluorinated oligomers may suitably be employed. Suitable fluorinated oligomers arc disclosed in published PCT patent application WO 00/17712, such as those prepared from the following monomer combinations: TFE/norbornene, TFE/nonbornene carboxylic acid, TFE/norbonene/ nonbornene carboxylic acid, TFE/nonbornene/acrylic acid, TFE/nonbornene/ethylene, TFE/ nonbornene/methacrylic acid, TFE/nonbornene/tert-butyl acrylatc, TFE/nonbornene/tert-butyl acrylate/acrylic acid, TFE/nonbornene/tert-butyl acrylate/methacrylic acid, TFE/nonbornene/vinyl acetate, TFE/nonbornene/vinyl alcohol, TFE/nonbornene/5-norbornene-2-carboxylic acid tert-butyl ester, TFE/1-adamantane-carboxylate vinyl ester, TFE/adamantanemethylvinyl ether and TFE/norbornanemcthylvinyl ether.

Particularly suitable inorganic monomers, oligomers and polymers include those containing fluoride such as silicon-fluoride compounds, silicon-oxy-fluoride compounds and the like.

Optionally, the present antireflective compositions may also include a porogen. The term "porogen" refers to a pore forming material, such as, but not limited to a polymeric material or particle, dispersed in the organo polysilica material that is subsequently removed to yield pores, voids or free volume in the dielectric material. The porogens useful in the present invention are any which may be removed providing voids, pores or free volume in the dielectric material chosen and reduce the dielectric constant of such material, particularly those dielectric materials having low dielectric constants ("low-k"), A low-k dielectric material is any material having a dielectric constant less than about 4.

The removable porogens useful in the present invention are not substantially removed under the processing conditions used to cure the B-staged dielectric material or pattern the photoresist. The present porogens are preferably removed under conditions which do not substantially degrade or otherwise adversely affect the cured organo polysilica material.

A wide variety of removable porogens may be used in the present invention. The removable porogens may be polymers such as polymeric particles (i.e. not linear polymers), or may be monomers or polymers that are co-polymerized with an organo polysilica monomer to form a block copolymer having a labile (removable) component. In an alternative embodiment, the porogen may be pre-polymerized with the organo polysilica monomer to form the B-staged organo polysilica material which may be monomcric, oligomeric or polymeric. Such pre-polymerized B-staged material is then cured to form the antireflective coating. For a description of porogens which may be used, see, for example, U.S. Patent No. 5,895,263 (Carter et al.) and 6,093,636 (Carter et al.) and U.S. Patent Application Ser. No. 09/460,326 (Allen et al.)

Preferably, the removable porogen is substantially non-aggregated or non-agglomerated in the B-staged organo polysilcia material. Such non-aggregation or non-agglomeration reduces or avoids the problem of killer pore or channel formation in the cured organo polysilica material. It is preferred that the removable porogen is a porogen particle or is co-polymerized with the organo polysilica monomer, and more preferably a porogen particle. It is further preferred that the porogen particle is substantially compatible with the B-staged organo polysilica material. By "substantially compatible" is meant that a composition of B-staged organo polysilica material and porogen is slightly cloudy or slightly opaque. Preferably, "substantially compatible" means at least one of a solution of B-staged organo polysilica material and porogen, a film or layer including a composition of B-staged organo polysilica material and porogen, a composition including an organo polysilica matrix material having porogen dispersed therein, and the resulting porous cured organo polysilica material after removal of the porogen is slightly cloudy or slightly opaque. To be compatible, the porogen must be soluble or miscible in the B-staged organo polysilica material, in the solvent used to dissolve the B-staged organo polysilica material or both. Suitable compatibilized porogens are those disclosed in co-pending U.S. Patent Application Ser. No. 09/460,326 (Allen et al.). Other suitable removable particles are those disclosed in U.S. Patent No. 5,700,844.

Substantially compatibilized porogens, typically have a molecular weight in the range of 10,000 to 1,000,000, preferably 20,000 to 500,000, and more preferably 20,000 to 100,000. The polydispersity of these materials is in the range of 1 to 20, preferably 1.001 to 15, and more preferably 1.001 to 10. It is preferred that such substantially compatibilized porogens are crosslinked. Typically, the amount of cross-linking agent is at least about 1% by weight, based on the weight of the porogen. Up to and including 100% cross-linking agent, based on the weight of the porogen, may be effectively used in the particles of the present invention. It is preferred that the amount of cross-linker is from about 1% to about 80%, and more preferably from about 1% to about 60%. A wide variety of cross-linkers may be used in the preparation of such porogens.

Suitable block copolymers having labile components useful as removable porogens are those disclosed in U.S. Patent Nos. 5,895,263, 5,776,990 and 6,093,636. Such block copolymers may be prepared, for example, by using as pore forming material highly branched aliphatic esters that have functional groups that arc further functionalized with appropriate reactive groups such that the functionalized aliphatic esters are incorporated into, i.e. copolymerized with, the vitrifying polymer matrix. Such block copolymers are suitable for forming porous organic dielectric materials, such as benzocyclobutenes, poly(aryl esters), poly(ether ketones), polycarbonates, polynorbornenes, poly(arylene ethers), polyaromatic hydrocarbons, such as polynaphthalene, polyquinoxalines, poly(perfluorinated hydrocarbons) such as poly(tetrafluoroethylenc), polyimides, polybenzoxazoles and polycycloolefins.

To be useful in forming porous dielectric materials, the porogens of the present invention must be at least partially removable under conditions which do not adversely affect the cured organo polysilica material, preferably substantially removable, and more preferably completely removable. By "removable" is meant that the porogen depolymerizes, degrades or otherwise breaks down into volatile components or fragments which are then removed from, or migrate out of, the cured organo polysilica material yielding pores or voids. Any procedures or conditions which at least partially remove the porogen without adversely affecting the cured organo polysilica matrix material may be used. Such procedures are well known to those skilled in the art. It is preferred that the porogen is substantially removed. Typical methods of removal include, but are not limited to: exposure to heat, pressure, vacuum or radiation such as, but not limited to, actinic, infrared ("IR"), microwave, UV, x-ray, gamma ray, alpha particles, neutron beam or electron beam. It will be appreciated that more than one method of removing the porogen or polymer may be used, such as a combination of heat and aetinic radiation. It is preferred that the matrix material is exposed to heat or UV light to remove the porogen. It will also be appreciated by those skilled in the art that other methods of porogen removal, such as by atom abstraction, may be employed.

The porogens of the present invention can be thermally removed under vacuum, nitrogen, argon, mixtures of nitrogen and hydrogen, such as forming gas, or other inert or reducing atmosphere. The porogens of the present invention may be removed at any temperature that is higher than the thermal curing temperature and lower than the thermal decomposition temperature of the dielectric matrix material. Typically, the porogens of the present invention may be removed at temperatures in the range of 150° to 450° C and preferably in the range of 250° to 425° C. Typically, the porogens of the present invention are removed upon heating for a period of time in the range of 1 to 120 minutes After removal from the dielectric matrix material, 0 to 20% by weight of the porogen typically remains in the porous dielectric material.

The antireflective compositions of the present invention may also optionally include one or more cross-linking agents and a cross-linking catalyst. Any cross-linking agent that crosslinks the B-staged organo polysilica materials, the optional additional components or both to form a cured antireflective coating layer is suitable, Such cross-linking agents arc well known in the art and are generally commercially available from a variety of sources, and include, but arc not limited to, tetraalkylorthosilicates such as tetraethylorthosilicate, titanium alkoxides, zirconium alkoxides, aluminum alkoxides, tin alkoxides, lanthanide alkoxides, boron alkoxides, germanium alkoxides, and mixtures thereof. The amounts of such cross-linking agents are typically from about 1 to about 25 % by weight, based on the total weight of the composition. The cross-linking catalysts useful in the present invention are typically bases. More than one cross-linking catalyst may be advantageously used in the present invention.

The cross-linking catalysts are typically added to present compositions in an amount sufficient to catalyze the curing of the B-staged organo polysilica materials with one or more cross-linking agents. A typical range of cross-linking catalyst is from 0.1 to 15 percent by weight, based on the weight of the B-staged organo polysilica material and cross-linking agent, and preferably 1 to 10 percent by weight.

Typically, the present antireflective compositions may be prepared by dissolving, suspending or dispersing the B-staged organo polysilica materials, along with any additional components and optional additives, in one or more suitable solvents. Such suitable solvents include, but are not limited to: ketone solvents such as acetone, methyl ethyl ketone, cyclohexanone, methyl isoamyl ketone and 2-heptanone; polyhydric alcohols and derivatives thereof such as ethyleneglycol, ethyleneglycol monoacetate, diethyleneglycol, diethyleneglycol monoacetate, propyleneglycol, propyleneglycol monoacetate, dipropyleneglycol and dipropyleneglycol monoacetate as well as monomethyl, monoethyl, monopropyl, monobutyl and monophenyl ethers thereof; cyclic ether solvents such as dioxane; ester solvents such as methyl lactate, ethyl lactate, methyl acetate, ethyl acetate, butyl acetate, methyl pyruvate, ethyl pyruvate, methyl methoxypropionate and ethyl ethoxypropionate; and amide solvents such as N,N-dimethyl formamide, N,N-dimethyl acetamide, N-methyl-2-pyrrolidone, 3-ethoxycthyl propionate, 2-heptanone, γ-butyrolactone, and mixtures thereof.

Typically, the solids content of the present antireflective compositions varies from about 5 to about 35 percent by weight, based on the total weight of the composition, but may be higher or lower, The B-staged organo polysilica material should be present in an amount sufficient to provide a film coating layer and absorption and/or attenuation of the radiation used to image the photoresist.

Such antireflective compositions may be applied to a substrate by any known means, such as spin coating, dipping, roller coating and the like. When the compositions are applied by spin coating, the solids content of the coating solution can be adjusted to provide a desired film thickness based upon the specific spinning equipment utilized, the viscosity of the solution, the speed of the spinner and the amount of time allowed for spinning.

Once the antireflective composition is coated on a substrate surface, it is dried by heating to remove any solvent. It is preferably dried until the coating is tack free. An advantage of the present invention is that the viscosity of the present antireflective compositions is lower than conventional photoresists providing more application process control and reduced defects during imaging. Also, films of the present photoresist compositions have greater film uniformity than those of conventional antireflective compositions.

After the antireflective composition is dried, it is optionally heated or subjected to radiation to form a cured antireflective coating layer. The curing of the organo polysilica material may be by any means known in the art including, but not limited to, heating to induce condensation or e-beam irradiation to facilitate free radical coupling of the oligomer or monomer units. Typically, the B-staged material is cured by hcating at an elevated temperature, e.g. either directly, e.g. heated at a constant temperature such as on a hot plate, or in a step-wise manner. Typically, the organo polysilica material is first annealed at a temperature of from about 200° to about 350°C.

When the antireflective composition contains one or more cross-linking agents, it is preferred that the composition is cured. Such curing helps to reduce intermixing with a previously applied or subsequently applied photorcsist. An advantage of the present compositions is that the amount of cross-linking agent used in the antireflective compositions can be eliminated or reduced, as compared to conventional antireflective compositions. While not wishing to be bound by theory, it is believed that such reduction in the amount of cross-linker is due to the B-staged organo polysilica materials being capable of self-cross-linking.

When the present antireflective compositions are used as BARCs, a photoresist is subsequently applied after curing. The photoresist is imaged through a mask in a conventional manner.

The antireflective compositions of the present invention are suited for use with photoresists activated by a short exposure wavelength, particularly a sub-300 nm, such as UV, and more preferably a sub-200 nm exposure wavelength. Particularly preferred wavelengths include 248, 193 and 157 nm. However, the antircflective compositions of the present invention may also be used with photoresists that are imaged at higher wavelengths, such as, but not limited to, visible, e-beam and x-ray.

Following exposure, the photoresist is optionally baked, such as at temperatures ranging from about 70° C to 160°C. Thereafter, the photoresist is developed. The exposed resist film is rendered positive working by employing a polar developer, preferably an aqueous based developer, such as quarternary ammonium hydroxide solutions, such as tetra-alkyl ammonium hydroxide, preferably a 0.26 N tetramethylammonium hydroxide; various amine solutions, such as ethylamine, n-propylamine, diethylamine, triethylamine or methyl diethylamine; alcohol amines, such as diethanolamine, triethanolamine; cyclic amines, such as pyrrole, pyridine, and the like. One skilled in the art will appreciate which development procedures should be used for a given system.

After development of the photoresist coating, the developed substrate may be selectively processed on those areas bared of resist, for example, by chemically etching or plating substrate areas bared of resist in accordance with procedures known in the art. For the manufacture of microelectronic substrates, e.g. the manufacture of silicon dioxide wafers, suitable etchants include, but are not limited to, a gas etchant, such as a chlorine- or fluorine-based etchant, such as Cl₂ or CF₄/CHF₃ etchant applied as a plasma stream. After such processing, the resist may he removed from the processed substrate using any stripping procedures known in the art.

An advantage of the present antireflective compositions is that the compositions may be carefully controlled so as to provide etch rates substantially matched to the etch rate of the underlying dielectric layer. Another advantage of the present antireflective compositions is that due to their high etch resistance, they are useful as cap layers for dielectric layers. The present compositions are thus suitable for use as cap layers over inorganic and organic dielectric materials, and particularly suitable for use as cap layers for organic dielectric materials.

Antireflective compositions including the polymeric particles of the present invention are useful in all applications where antireflective compositions are typically used. The antireflective compositions of the present invention may be used as TARCs or BARCs, but are preferably used as BARCs. For example, the compositions may be applied over silicon wafers or silicon wafers coated with silicon dioxide for the production of microprocessors and other integrated circuit components. Aluminum-aluminum oxide, gallium arsenide, ceramic, quartz, copper, glass and the like are also suitably employed as substrates for the antireflective compsitions of the invention. When the present compositions are used as TARCs, they may be applied over a wide variety of photoresist compositions.

It will be appreciated by those skilled in the art that the present antireflective compositions may be combined with one or more conventional antireflective compositions to provide a wide range of desired properties.

The compositions of the present invention may suitably be used in optoelectronic applications, such as wave guides or light pipes.

The following examples are presented to illustrate further various aspects of the present invention, but are not intended to limit the scope of the invention in any aspect.

### Example 1

An antireflective coating layer is prepared by spin-coating a composition of anthracenyl silsesquioxanc on silicon wafer that contains a silicon dioxide dielectric layer. After spin-coating, the anthracenyl silsesquioxane is cured by heating the wafer to 130° C for 60 seconds. A photoresist, UV6™ (available from Shipley Company, Marlborough, Massachusetts) is then applied. The wafer is then heated at 120° C for 90 seconds. The photoresist is then imaged through a mask at 248 nm and is then developed to provide a relief image.

### Example 2

The procedure of Example 1 is repeated except that a composition of anthracenyl silsesquioxane and phenyl silsesquioxane is spin-coated on a silicon wafer.

### Example 3

The procedure of Example I is repeated except that a composition of octyl silsesquioxane is spin-coated on a silicon wafer. A photoresist suitable for imaging at 157 nm is used instead of UV6™.

### Example 4

The procedure of Example 3 is repeated except that a composition of octyl silsesquioxane and butyl silsesquloxane is spin-coated on a silicon wafer.

### Example 5

The procedure of Example I is repeated except that a composition of anthracenyl silsesquioxane containing a porogen particle at 20% by weight loading, based on the total weight of the antireflective composition, is spin-coated on a silicon wafer. After the photoresist is exposed, the porogen is removed by heating the sample at 350° C for 60 minutes.

## Claims

1. A composition useful as an antireflective coating comprising one or more B-staged organo polysilica materials having the formula
((RR¹SiO)ₐ(R²SiO_{1.5})_{b}(R³SiO_{1.5})_{c}(SiO₂)_{d})ₙ
wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl.

2. The composition of claim 1 wherein the B-staged organo polysilica materials arc selected from iso-butyl silsesquioxane, n-butyl silsesquioxane, n-octyl silsesquioxane, cyclohexyl silsesquioxane, tert-butyl silsesquioxane, phenyl silsesquioxane, tolyl silscsquioxane, anthracenyl silsesquioxane, naphthalenyl silsesquioxane or mixtures thereof.

3. The composition of claim 1 wherein at least one of R, R¹ and R² is selected from butyl, pentyl, hexyl, heptyl, octyl, nonyl, decyl, dodecyl, tetradecyl, heptadecyl or octadecyl.

4. The composition of claim 1 further comprising one or more polymers comprising as polymerized units one or more fluorinated monomers, one or more fluorinated cross-linkers or a mixture thereof.

5. The composition of claim 4 wherein the fluorinated monomers are selected from fluorinated (meth)acrylates, (meth)acrylamides, fluorocycloalkyl (meth)acrylatce, fluoroalkylsulfoamidoethyl (meth)acrylate, fluoroalkylamidoethyl (meth)acrylate, fluoroalkyl (meth)acrylamide, fluoroalkylpropyl (meth)acrylate, fluoroalkylethyl poly(alkylencoxide) (meth)acrylate, fluoroalkylsulfocthyl (meth)acrylate, αH,αH,ωH,ωH-perfluoroalkanediol di(meth)acrylate, β-substituted fluoroalkyl (meth)acrylate, fluorinated vinyl ethers, fluorinatedalcohol vinyl ethers, fluorinated vinyl acetates, fluorinatedalkyl vinyl acetates, fluorinated aromatics, fluorinated hydroxyaromatics, fluorinated ethylene, fluorinated α-olefins; fluorinated dienes, and fluorinated heterocycles.

6. The composition of claim 5 wherein the fluorinated monomers are selected from 3-fluorostyrene, 4-fluorosytrene, perfluorooctylethyl (meth)acrylate, perfluorooctylethyl (meth)acrylate, octafluoropentyl (meth)acrylate, trifluoroethyl (meth)acrylate, tetrafluoropropyl (meth)acrylate, vinylidene fluoride, trifluoroethylene, tetrafluoroethylene, perfluoro-(2,2-dimethyl-1,3-dioxole) and perfluoro-(2-methylen-4-methyl-1,3-dioxolane).

7. The composition of claim 1 further comprising one or more fluorinated oligomers selected from TFE/norbornene, TFE/nonbornene carboxylic acid, TFE/norbonene/nonbomene carboxylic acid, TFE/ nonbornene/acrylic acid, TFE/nonbornene/ethylene, TFE/ nonbornene/methacrylic acid, TFE/nonbornene/tert-butyl acrylate, TFE/nonbornene/tert-butyl acrylate/acrylic acid, TFE/nonbomene/tert-butyl acrylate/methacrylic acid, TFE/nonbornenc/vinyl acetate, TFE/nonbornene/vinyl alcohol, TFE/nonbornene/5-norbornene-2-carboxylic acid tert-butyl ester, TFE/1-adamantane-carboxylatc vinyl ester, TFE/adamantanemethylvinyl ether and TFE/norbomancmethylvinyl ether.

8. A method for forming an antireflective coating layer comprising the step of disposing on a substrate a composition comprising one or more B-staged organo polysilica materials having the formula
((RR¹SiO)ₐ(R²SiO_{1.5})_{b}(R³SiO_{1.5})_{c}(SiO₂)_{d})ₙ
wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl.

9. The method of claim 8 wherein the B-staged organo polysilica materials are selected from iso-butyl silsesquioxane, n-butyl silsesquioxane, n-octyl silsesquioxane, cyclohexyl silsesquioxane, tert-butyl silsesquioxane, phenyl silsesquioxane, tolyl silsesquioxane, anthracenyl silsesquioxane, naphthalenyl silsesquioxane or mixtures thereof.

10. The method of claim 8 wherein at least one of R, R¹ and R² is selected from butyl, pentyl, hexyl, heptyl, octyl, nonyl, decyl, dodecyl, tetradecyl, heptadecyl or octadecyl.

11. The method of claim 8 further comprising one or more polymers comprising as polymerized units one or more fluorinated monomers, one or more fluorinated cross-linkers or a mixture thereof.

12. The method of claim 11 wherein the fluorinated monomers are selected from fluorinated (meth)acrylates, (meth)acrylamides, fluorocycloalkyl (meth)acrylate, fluoroalkylsulfoamidocthyl (meth)acrylate, fluoroalkylamidoethyl (meth)acrylatc, fluoroalkyl (meth)acrylamide, fluoroalkylpropyl (meth)acrylatc, fluoroalkylethyl poly(alkylencoxidc) (meth)acrylate, fluoroalkylsulfocthyl (meth)acrylate, αH,αH,ωH,ωH-perfluoroalkanediol di(meth)acrylate, β-substituted fluoroalkyl (meth)acrylate, fluorinated vinyl ethers, fluorinatedalcohol vinyl ethers, fluorinated vinyl acetates, fluorinatedalkyl vinyl acetates, fluorinated aromatics, fluorinated hydroxyaromatics, fluorinated ethylene, fluorinated α-olefins; fluorinated dienes, and fluorinated heterocycles.

13. The method of claim 11 wherein the fluorinated monomers are selected from 3-fluorostyrene, 4-fluorosytrene, perfluorooctylethyl (meth)acrylate, perfluorooctylethyl (meth)acrylate, octafluoropentyl (meth)acrylate, trifluoroethyl (meth)acrylate, tetrafluoropropyl (meth)acrylate, vinylidene fluoride, trifluoroethylene, tetrafluoroethylene, perfluoro-(2,2-dimethyl-1,3-dioxole) and pcrfluoro-(2-methylene-4-methyl-1,3-dioxolane).

14. The method of claim 8 further comprising one or more fluorinated oligomers selected from TFE/norbornene, TFE/nonbornene carboxylic acid, TFE/norbonene/ nonbornene carboxylic acid, TFE/ nonbomene/acrylic acid, TFE/nonbornene/ethylene, TFE/ nonbornene/methacrylic acid, TFE/nonbornene/tert-butyl acrylate, TFE/nonbornene/tert-butyl acrylate/acrylic acid, TFE/nonbornene/tert-butyl acrylate/methacrylic acid, TFE/nonbomene/vinyl acetate, TFE/nonbornene/vinyl alcohol, TFE/nonbornene/5-norbornene-2-carboxylic acid tert-butyl ester, TFE/1-adamantane-carboxylate vinyl ester, TFE/adamantanemethylvinyl ether and TFE/norbornanemethylvinyl ether.

15. A method for manufacturing an electronic device comprising the steps of: a) disposing on a substrate an antireflective composition comprising one or more B-staged organo polysilica materials having the formula
((RR¹SiO)ₐ(R²SiO_{1.5})_{b}(R³SiO_{1.5})_{c}(SiO₂)_{d})ₙ
wherein R, R¹, R² and R³ are independently selected from hydrogen, (C₁-C₂₀)alkyl, substituted (C₁-C₂₀)alkyl, aryl, and substituted aryl; a, c and d are independently a number from 0 to 1; b is a number from 0.2 to 1; n is integer from about 3 to about 10,000; provided that a + b + c + d = 1; and provided that at least one of R, R¹ and R² is aryl, substituted aryl, (C₄-C₂₀)alkyl or substituted (C₄-C₂₀)alkyl; b) curing the one or more B-staged organo polysilica materials to form a cured organo polysilica antireflective coating layer; c) disposing a photoresist on the cured organo polysilica antireflective coating layer; and d) patterning the photoresist.

16. The method of claim 15 wherein the B-staged organo polysilica materials are selected from iso-butyl silsesquioxane, n-butyl silsesquioxane, n-octyl silsesquioxane, cyclohexyl silsesquioxane, tert-butyl silsesquioxane, phenyl silsesquioxane, tolyl silsesquioxane, anthracenyl silsesquioxane, naphthalenyl silsesquioxane or mixtures thereof.

17. The method of claim 15 wherein at least one of R, R¹ and R² is selected from butyl, pentyl, hexyl, heptyl, octyl, nonyl, decyl, dodecyl, tetradecyl, heptadecyl or octadecyl.

18. The method of claim 15 further comprising one or more polymers comprising as polymerized units one or more fluorinated monomers, one or more fluorinated cross-linkers or a mixture thereof.

19. The method of claim 18 wherein wherein the fluorinated monomers are selected from fluorinated (meth)acrylates, (meth)acrylamides, fluorocycloalkyl (meth)acrylate, fluoroalkylsulfoamidoethyl (meth)acrylate, fluoroalkylamidoethyl (meth)acrylate, fluoroalkyl (meth)acrylamide, fluoroalkylpropyl (meth)acrylate, fluoroalkylethyl poly(alkyleneoxide) (meth)acrylate, fluoroalkylsulfocthyl (meth)acrylate, αH,αH,ωH,ωH-perfluoroalkanediol di(meth)acrylate, β-substituted fluoroalkyl (meth)acrylate, fluorinated vinyl ethers, fluorinatedalcohol vinyl ethers, fluorinated vinyl acetates, fluorinatedalkyl vinyl acetates, fluorinated aromatics, fluorinated hydroxyaromatics, fluorinated ethylene, fluorinated α-olefins; fluorinated dienes, and fluorinated heterocycles.

20. An electronic device comprising a dielectric layer and an organo polysilica coating layer disposed thereon.
